Europäisches Patentamt

European Patent Office

Office européen des brevets

(19)

(11) Numéro de publication: **0 368 760**
**A2**

## (12) DEMANDE DE BREVET EUROPEEN

(21) Numéro de dépôt: 89403087.3

(51) Int. Cl.5 **G01R 13/06**

(22) Date de dépôt: 08.11.89

(30) Priorité: 09.11.88 FR 8814626

(43) Date de publication de la demande:
16.05.90 Bulletin 90/20

(84) Etats contractants désignés:
AT BE CH DE ES GB GR IT LI LU NL SE

(71) Demandeur: MANUFACTURE
D'APPAREILLAGE ELECTRIQUE DE CAHORS
B.P.149 Regourd
F-46003 Cahors Cédex(FR)

Demandeur: ELECTRICITE DE FRANCE
32 Boulevard Lascrosses
F-31002 Toulouse(FR)

(72) Inventeur: Savary, Pierre
34 rue du Petit Tour
F-87000 Limoges(FR)
Inventeur: Tougne, Daniel
15 Boulevard Gambetta Résidence le
Bordeaux
F-46000 Cahors(FR)

(74) Mandataire: Bouju, André
Cabinet Bouju 38 avenue de la Grande
Armée
F-75017 Paris(FR)

(54) **Dispositif autonome de détection de défauts sur un réseau électrique et procédé s'y rapportant.**

(57) Le dispositif autonome de détection de défauts sur un réseau électrique comprend des moyens (26) pour détecter la présence de défauts et délivrer des informations de détection, reliés audit réseau par des bornes de raccordement (25), des moyens de contrôle et de traitement (15) reliés auxdits moyens de détection (26) pour traiter les informations de détection et générer des données d'analyse de défaut, des moyens de stockage permanent (16) reliés auxdits moyens de contrôle et de traitement (15) pour stocker les données d'analyse, et des moyens autonomes de stockage et de fourniture d'énergie (31) pour tout ou partie des moyens précités.

Les moyens de détection (15) détectent en outre les instants d'apparition et de disparition des défauts et les moyens de contrôle et de traitement (15) déterminent la durée respective de chacun desdits défauts détectés.

Utilisation pour l'analyse de la qualité de service d'une réseau électrique.

FIG_3

## Dispositif autonome de détection de défauts sur un réseau électrique et procédé s'y rapportant

La présente invention concerne un dispositif autonome de détection de défauts sur un réseau électrique. Elle vise également le procédé pour la détection de ces défaut, notamment au moyen du dispositif précité.

Les services de distribution d'énergie n'arrivent pas toujours à identifier les discontinuités de tension survenant sur leur réseau et ne peuvent pas alors palier à ces défauts.

Il y a discontinuité quand la tension descend en dessous d'une valeur critique, interdisant ainsi le fonctionnement des appareils qui sont raccordés au réseau concerné par la discontinuité.

Il est donc nécessaire pour l'exploitant d'un réseau électrique de disposer de dispositifs de détection de défauts placés aux endroits stratégiques de son réseau, afin de pouvoir améliorer l'exploitation de son réseau.

On connaît déjà selon le brevet français 2 485 723, un système de prise d'enregistrement et de collecte de mesure. Ce système comprend, en plusieurs points de mesure, un dispositif comportant un capteur de mesure au moins, un bloc interface assurant la conversion et/ou le multiplexage, une mémoire locale et une horloge associée à un séquenceur pour exciter le capteur et contrôler le bloc interface et la mémoire. Les résultats de mesure, enregistrés dans les mémoires locales des différents dispositifs sont rassemblés périodiquement dans une mémoire de collecte apte à être branchée sur chaque mémoire locale et à être amenée à des moyens de traitement de mesures centralisés.

Dans ce système, les instants de mesure sont fixés par l'horloge et il n'est donc pas possible de détecter un défaut qui peut bien évidemment survenir à tout instant. En outre, à chaque instant prédéterminé de mesure, une ou plusieurs grandeurs physiques sont converties, éventuellement multiplexées puis stockées dans la mémoire locale. Un tel système ne permet donc pas le stockage exclusif de données concernant les défauts détectés sur un réseau électrique.

On connaît aussi, par le brevet américain 4 558 275, un système de surveillance de tension secteur. Ce système se présente sous la forme de deux blocs fonctionnels indépendants, une unité de détection et une unité d'impression, qui peuvent être reliés par une liaison série. L'acquisition de la tension secteur et sa comparaison avec des seuils d'effondrement et de surtension n'est effectuée qu'à des instants prédéterminés qui sont les instants de début de chaque demi-cycle du secteur. Ainsi, les durées de défaut mesurées sont nécessairement des multiples entiers de la demi-période électrique du secteur analysé. Un circuit de détection de passage par zéro de la tension fournit le signal de synchronisation nécessaire. L'unité de détection des défauts sur le réseau comporte un microprocesseur, une mémoire morte EPROM, une mémoire RAM et un circuit horloge. Elle comprend en outre un convertisseur analogique/numérique, des détecteurs de demi-cycle d'impulsion et de mode commun, et un compteur.

L'énergie nécessaire à l'alimentation de l'unité est directement prélevée sur le secteur analysé et est convertie en tension continue. Seuls la mémoire RAM et le circuit horloge sont alimentés par une pile en cas d'effondrement prolongé de la tension secteur.

Les brevets français et américains précités présentent en commun la caractéristique limitative suivante : la grandeur surveillée n'est sondée qu'à des instants prédéterminés, fixés dans le premier cas, par une horloge appartenant au dispositif lui-même, et dans le second cas par les passages par zéro de la tension observée. Il est donc impossible de détecter l'instant de début d'un défaut avec de tels dispositif et donc d'obtenir une information précisée sur sa durée.

Le but de la présente invention est de remédier à ces inconvénients en proposant un dispositif autonome de détection de défauts sur un réseau électrique, comprenant :
- des moyens pour détecter la présence de défauts sur le réseau électrique et délivrer des informations de détection, reliés audit réseau électrique par des bornes de raccordement,
- des moyens de contrôle et de traitement reliés auxdits moyens de détection pour traiter lesdites informations de détection et générer des données d'analyse de défaut,
- des moyens de stockage permanent reliés auxdits moyens de contrôle et de traitement pour stocker lesdites données d'analyse,
et des moyens autonomes de stockage et de fourniture d'énergie pour tout ou partie des moyens précités.

Suivant l'invention, ce dispositif est caractérisé en ce que les moyens de détection détectent en outre les instants d'apparition et de disparition des défauts et en ce que les moyens de contrôle et de traitement déterminent la durée respective de chacun desdits défauts.

Ainsi, contrairement aux dispositifs de l'art antérieur où les instants d'observation de la consigne à analyser, la tension du réseau par exemple, étaient prédéterminés, dans le dispositif selon l'invention, les moyens de détection permettent d'obtenir la durée d'un défaut par la connaissance des instants d'apparition et de disparition de ce défaut. Ces informations de durée ont une grande importance lorsqu'il s'agit d'étudier les discontinuités de service sur un réseau.Une étude statistique peut alors être effectuée afin de localiser et d'identifier les causes de discontinuité.

Dans une version préférée de réalisation de l'invention, le dispositif comprend en outre des moyens pour contrôler la fourniture d'énergie par les moyens autonomes de stockage et de fourniture d'énergie aux moyens de contrôle et de traitement en fonction de la détection éventuelle de défauts par lesdits moyens de détection et de demandes d'activation desdits moyens de contrôle et de traitement extérieurs audit dispositif.

Ces moyens de contrôle permettent de garantir une autonomie élevée du dispositif selon l'invention dans la mesure où les moyens de contrôle et de traitement ne sont alimentés et donc activés en pratique que lorsqu'un défaut apparaît ou qu'un opérateur extérieur audit dispositif désire accéder aux données d'analyse de défauts. Ainsi, la source d'autonomie d'énergie qui peut être une pile ou une batterie voit sa durée de vie rallongée.

Suivant une version avantageuse de l'invention, les moyens pour contrôler la fourniture d'énergie commandent l'alimentation en énergie des moyens de contrôle et de traitement par les moyens autonomes de stockage et de fourniture d'énergie au moins pendant toute la durée de chaque défaut éventuel détecté par les moyens de détection et jusqu'à ce que les opérations de traitement et de génération des données d'analyse par les moyens de contrôle et de traitement et les opérations de stockage dans les moyens de stockage permanent aient été achevées.

Cette disposition permet le maintient de l'alimentation des moyens de contrôle et de traitement au-delà de la durée du défaut et ainsi l'analyse et le stockage des données. Les moyens de contrôle et de traitement sont ensuite mis hors service pour limiter la consommation d'énergie du dispositif.

Dans une autre version avantageuse du dispositif selon l'invention, les moyens de contrôle et de traitement comportent des moyens de comptage pour déterminer sensiblement la durée d'un défaut éventuel à partir des informations délivrées par les moyens de détection, et des moyens pour associer à chaque tranche de durée appartenant à un ensemble de tranches de durée prédéterminées, un nombre égal au nombre de défauts détectés dont la durée est sensiblement comprise dans ladite tranche de durée, ces nombres de défauts par tranche de durée étant réactualisés par les moyens de contrôle et de traitement lors de chaque détection et stockés dans lesdits moyens de stockage permanent.

On dispose ainsi d'une première analyse des discontinuités en un point du réseau ; cette analyse peut fournir des informations précieuses sur la répétitivité d'un défaut et sur la cause éventuelle de certains défauts en fonction de leur durée.

Dans une autre version avantageuse du dispositif selon l'invention, celui-ci comporte en outre des moyens d'horloge reliés aux moyens de contrôle et de traitement, pour fournir à ces derniers, lors de chaque détection et traitement d'un défaut, des informations de date et d'heure du début du défaut, et ces moyens d'horloge sont alimentés en énergie de façon permanente par les moyens de stockage et de fourniture d'énergie.

Il est ainsi possible d'effectuer des enregistrements de défauts comportant la date, l'heure et la durée des défauts. Ces enregistrements avec historique peuvent ensuite être exploités, notamment par comparaison entre enregistrements effectuées sur des dispositifs distincts placés en plusieurs points d'un réseau électrique.

Suivant un autre aspect de l'invention, le procédé de détection et d'analyse de défauts sur un réseau électrique, mis en oeuvre notamment dans le dispositif selon l'invention comprend une étape de détection de la présence d'un défaut sur le réseau électrique par des moyens de détection de défaut, suivie d'une étape d'analyse de ce défaut par des moyens de contrôle et de traitement et d'une étape de stockage des résultats d'analyse obtenus dans l'étape précédente dans des moyens de stockage permanent. Ce procédé est caractérisé en ce que l'étape d'analyse est initiée par l'apparition du défaut lui-même et en ce que, lors de cette étape, la durée du défaut est sensiblement déterminée par les moyens de contrôle et de traitement.

Ainsi, grâce à ce procédé, ce ne sont pas les moyens de contrôle et de traitement qui fixent les instants d'analyse de la consigne à surveiller, mais au contraire le défaut détecté qui détermine le début de l'étape d'analyse. Cette caractéristique permet d'obtenir la durée effective du défaut détecté.

D'autres particularités et avantages de l'invention apparaîtront encore dans la description ci-après.

Aux dessins annexés, données à titre d'exemples non limitatifs :

- la figure 1 est le schéma-bloc d'une première version du dispositif conforme à l'invention assurant la mémorisation des défauts par tranches de durée ;

- la figure 2 est le schéma-bloc d'une autre version du dispositif conforme à l'invention assurant une mémorisation historique des défauts ;

- la figure 3 est un schéma synoptique du dispositif autonome de détection conforme à l'invention dans sa configuration complète ;

- la figure 4 représente une réalisation effective du dispositif conforme à l'invention dans sa première version (mémorisation par tranches de durée) ;

- la figure 5 représente une réalisation du dispositif dans sa seconde version (mémorisation historique);

- la figure 6 est un organigramme simplifié du programme de détection et d'analyse stockée dans le microcontrôleur du dispositif conforme à l'invention,

- la figure 7 est schéma synoptique d'un système intégré d'analyse de qualité de service mettant en oeuvre plusieurs dispositifs de détection de défauts conformes à l'invention.

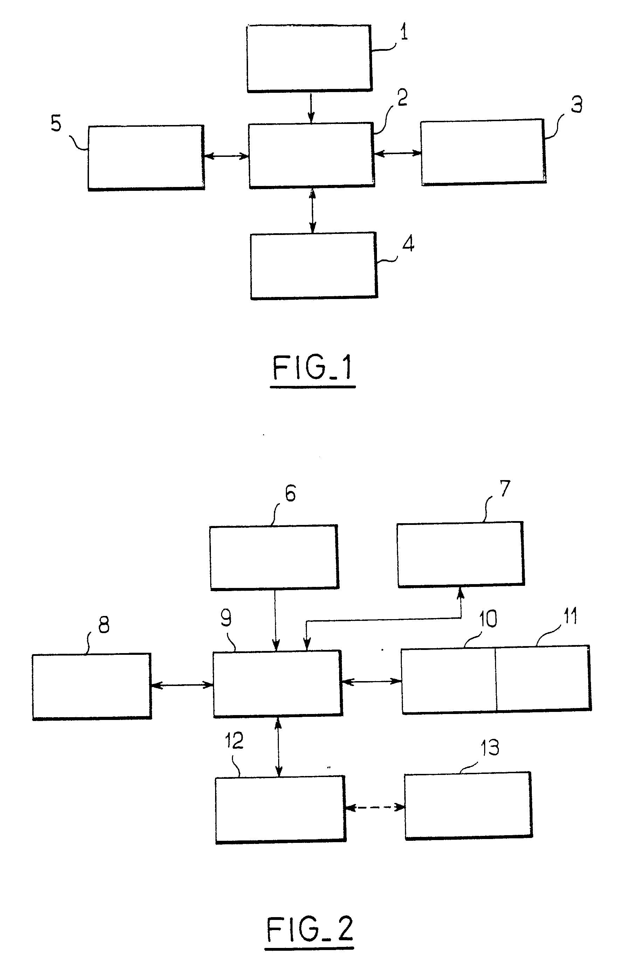

Dans une première version préférée de l'invention, le dispositif autonome de détection, effectue la mémorisation des défauts sur le réseau électrique par tranches de durée et peut être représenté dans son principe par le schéma synoptique de la figure 1.

Il comporte ainsi un module de capture 1, chargé de la surveillance d'une consigne, par exemple la tension ou le courant. Ce module fonctionne en tout ou rien et transmet son état par la mise en service d'un relais.

L'électronique qui le compose, dépend essentiellement du type de consigne à surveiller et de la précision souhaitée. Le module 1 tire son énergie de la consigne à surveiller ou directement d'une autre partie du dispositif. Il possède en outre un système de réglage de seuil de basculement par paliers.

Le module de capture 1 est relié à un module de traitement 2 qui comporte de préférence un microcontrôleur. Le module de traitement 2 a notamment pour fonctions de comptabiliser les temps de coupure et de faire une discrimination entre plusieurs tranches de coupure. Les différents types de traitement assurés par le module de traitement 2 seront décrits lors de l'explication détaillée du fonctionnement du dispositif.

Le module de traitement nécessite, d'une part, d'être alimenté par un module d'alimentation 5, et d'autre part, d'être associé à une mémoire de stockage 3.

Les composants du dispositif selon l'invention sont tous choisis pour que soit minimisée la consommation globale d'énergie du dispositif. Par ailleurs, comme cela sera expliqué dans la suite, le mode de fonctionnement choisi contribue lui aussi à limiter la consommation d'énergie.

Le module d'alimentation 5 peut comporter comme source d'énergie une pile classique qui alimente un régulateur de tension. Compte tenu de la faible consommation du module de traitement, une autonomie d'un an est envisageable.

La mémoire de stockage 3, non volatile, garantit une sécurité de rétention des données traitées en cas de disfonctionnement temporaire du dispositif.

Le résultat du traitement des défauts est affiché grâce à un module d'affichage et de contrôle 4 relié au module de traitement 2.

Le module d'affichage comporte de préférence un afficheur 8 digits à cristaux liquides. La très faible consommation de ce type d'afficheur permet son alimentation par le module d'alimentation 5.

Dans une seconde version préférée de l'invention, le dispositif selon l'invention assure un enregistrement des défauts avec historique (date, heure, durée). Il est représenté sous la forme d'un schéma synoptique sur la figure 2.

Outre les modules de capture 6, d'alimentation 8 et de traitement 9 respectivement identiques aux modules 1, 5, 2 de la première version, le dispositif comporte un module horloge 7 relié au module de traitement 9, des mémoires non volatiles de site 10 et de données 11, et un module convertisseur d'échanges 12 relié au module de traitement 9.

Le module horloge 5 est de préférence constitué d'un circuit intégré spécialisé muni d'un quartz. Il fournit les références temporaires nécessaires à l'enregistrement. Sa gestion est effectuée par le module de traitement 9. Le module 5 possède en outre un système d'alarme qui permet de réactiver le dispositif en cas d'incidents de longue durée et est alimenté par le module d'alimentation 8.

Le module convertisseur d'échanges 12 effectue la conversion de niveaux électriques de signaux émis par le dispositif afin de les rendre compatibles avec un terminal de saisie portable 13 qui peut être temporairement connecté au dispositif pour effectuer le transfert des données enregistrées en mémoire. Le module convertisseur 12 peut se résumer à un simple connecteur suivi de circuits de protection. Il peut être aussi constitué de circuits émetteurs-récepteurs infrarouges ou à ultra-sons. Si un haut niveau de protection mécanique est requis, l'utilisation d'un couplage électromagnétique s'avère judicieux.

Le terminal de saisie portable 13 possède de préférence un système d'affichage, une alimentation autonome et une mémoire de stockage suffisante.

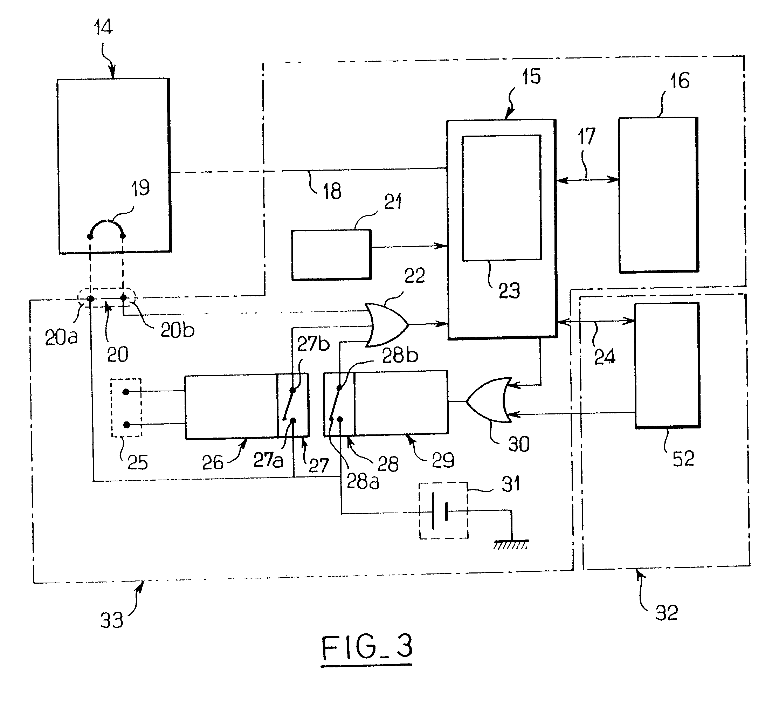

Le dispositif autonome de détection de défauts sur un réseau électrique comprend, dans une forme de réalisation particulière, en référence à la figure 3, une partie de détection et d'analyse de défauts 33, et une partie horloge 32, ces composants coopérant pour assurer la fonction d'analyse de la qualité de service d'un réseau avec enregistrement historique de coupures.

La partie 33 de détection et d'analyse comprend des moyens 26 pour détecter une coupure sur le secteur appliqué aux bornes de raccordement 25, qui commandent un relais 27, des moyens de contrôle et de traitement 15, par exemple un microcontrôleur, des moyens de stockage non volatile 16 reliés auxdits moyens de contrôle et de traitement 15.

Il comprend en outre une pile 31 ou tout autre dispositif capable de stocker de l'énergie et de la restituer sous forme d'une tension continue. Cette pile n'alimente le microcontrôleur que lorsqu'un défaut a été détecté par les moyens de détection 26 ou lorsqu'un terminal de saisie 14 est connecté au dispositif de détection et d'analyse par l'intermédiaire des bornes de raccordement 20 et d'une liaison série 18. Cette connexion provoque la mise en court-circuit des bornes 20 par le biais d'un strap 19.

Une porte logique OU 22 contrôle l'alimentation du microcontrôleur 15 et ses trois entrées sont respectivement reliées à l'une des bornes de raccordement 20b, à l'un des contacts du relais 27b et à l'un des contacts d'un relais 28b d'automaintien. Les trois autres contacts 20a, 27a et 28a sont reliés ensemble à la source de tension 31.

La fonction logique OU de la porte 22 assure que si l'un au moins des trois points 20b, 27b, 28b se trouve soumis à la tension de référence, le microcontrôleur est alors alimenté.

Le relais d'automaintien 28 est commandé par des moyens de commande 29 pilotés eux-mêmes par une porte logique OU 30 à deux entrées reliées respectivement à une ligne de sortie du microprocesseur 15 et à une ligne de sortie de l'horloge 52 qui est par ailleurs reliée au microcontrôleur 15 par une liaison série spécialisée 24. Un circuit de test de pile 21 est en outre relié au microcontrôleur 15.

Les moyens de détection de coupure 26 peuvent comporter par exemple un réseau de résistances et un pont de diodes relié au relais 27, par exemple un relais reed fermé au repos.

A titre d'exemple, la tension d'isolement bobine/contact est de 4 kv. Le relais 27 est pratiquement toujours alimenté. Afin de diminuer son échauffement, une tension de service assez faible, de l'ordre de 5 v, a été choisie. Les résistances d'alimentation sont surdimensionnées en puissance. La chaleur dégagée par ces résistances, pour peu que le boîtier soit relativement étanche, maintient une température constante, permettant ainsi d'utiliser des composants de gamme standard.

Les moyens de contrôle et de traitement 15 comportent de préférence un microcontrôleur de type INTEL 8051 muni d'une mémoire interne 23 de programme.

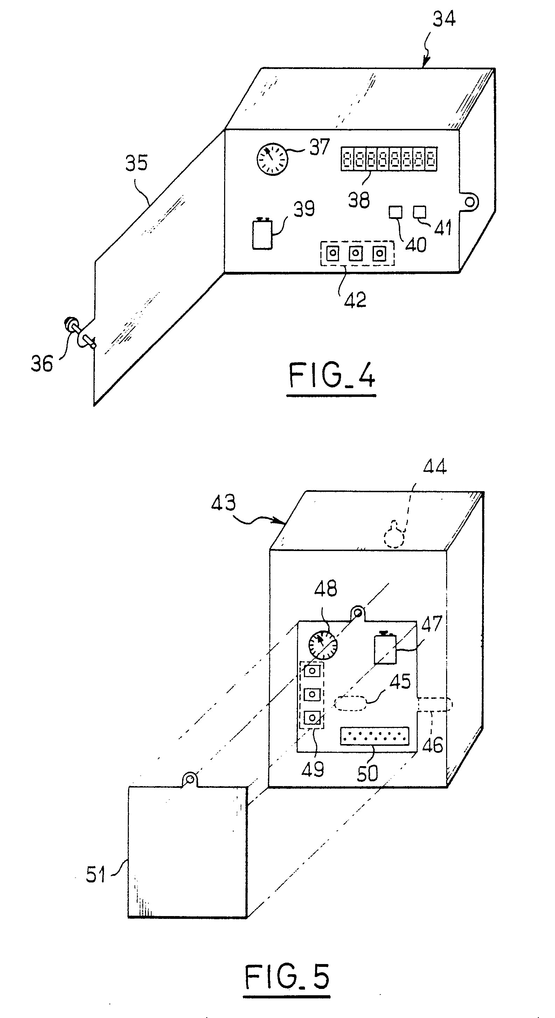

Le dispositif autonome de détection de défauts est implanté à proximité immédiate du point étudié sur le réseau électrique. Une réalisation pratique de la première version préférée du dispositif, -la mémorisation par tranches de durée-, est illustrée par la figure 4. Le dispositif selon l'invention est inclus dans un boîtier, qui peut par exemple être réalisé en matière plastique et dont la face avant est protégée en usage normal par un capot sur charnière 35 refermé grâce à une vis plombable 36.

La face avant comporte un commutateur 37 pour le réglage du seuil de basculement du module de capture 1 (figure 1), des afficheurs à cristaux liquides 38, une pile 39, par exemple de 9v, des bornes de raccordement 42 au réseau électrique, un bouton-poussoir 40 de remise à zéro de la mémoire 3 et un bouton-poussoir 41 de contrôle d'affichage.

La seconde version préférée de réalisation du dispositif selon l'invention est représentée dans une configuration pratique sur la figure 5.

Le dispositif autonome de détection est inclus dans un boîtier 43 dont la face arrière présente trois évidements 44, 45, 46 pour la fixation du boîtier sur une paroi. La face avant du boîtier présente une ouverture offrant l'accès aux composants d'entrée/sortie du dispositif et à la pile d'alimentation 47. Cette ouverture est, en temps ordinaire, masquée par une trappe de visite plombée 51. Les composants accessibles du dispositif sont un commutateur de réglage de consigne 48, des bornes de raccordement 49, la pile d'alimentation 47 et un connecteur 50 permettant le transfert des données stockées vers des afficheurs ou vers un terminal de saisie portable.

On va maintenant décrire le fonctionnement du dispositif autonome de détection de défauts sur un réseau électrique, dans la première version de réalisation, à savoir la mémorisation par tranches de durée. On va pour cela décrire en premier lieu des différents types de traitement confiés au microcontrôleur 15, en référence à la figure 3 dans laquelle la partie 33 de détection et d'analyse est commune aux deux versions précitées.

Le premier type de traitement effectué est la commande d'un compteur de durée interne au microcontrôleur 15. Le compteur de durée est mis en service à l'apparition d'un défaut sur le réseau et est arrêté lorsqu'il y a rétablissement de la consigne. Il est calibré en unités compatibles avec les phénomènes à analyser, par exemple, des dixièmes de secondes pour un analyseur de défaut de réseau. Les conditions de défaut et de rétablissement sont déduites de l'état d'un port du microcontrôleur 15.

Un autre traitement concerne la commande d'alimentation. Afin de minimiser la consommation du dispositif selon l'invention et de garantir ainsi une autonomie beaucoup plus grande, le dispositif contrôle sa propre alimentation. La mis sous tension est provoquée par un phénomène externe tel qu'un défaut ou une demande d'affichage. Il y a ensuite automaintien de l'alimentation jusqu'à ce que le phénomène incident ait été complètement traité. Le microcontrôleur 15 commande alors la déconnexion de l'alimentation via le relais 28, en référence à la figure 3.

Le microcontrôleur 15 assure aussi la détermination du numéro de tranche concerné par le défaut qui vient d'être détecté et dont la durée a été mesurée. Le microcontrôleur 15 s'assure que la durée du défaut est bien dans la tranche minimale autorisé. Puis il balaye la table des tranches prédéfinie en mémoire et affecte au défaut un numéro de tranche. Dans le cas où la durée du défaut n'est pas dans la tranche minimale autorisée, le microcontrôleur 15 se déconnecte sans traitement particulier.

Un autre traitement dévolu au microcontrôleur 15 est la gestion de la mémoire de données 16 ainsi que le transcodage des données. Celles-ci sont en effet stockées sous forme hexadécimale afin d'occuper moins de place. Par contre, pour faciliter la lecture des données par un opérateur, le microcontrôleur 15 effectue leur conversion sous forme décimale.

Le microcontrôleur 15 assure aussi le contrôle de l'alimentation en coopération avec le circuit de test de pile 21. Ce dernier comporte un comparateur avec tension de référence par diode Zener qui informe le microcontrôleur 15 sur l'activité de la pile.

L'état de la pile 39 est transmis aux afficheurs 38, en référence à la figure 4, en début de cycle de demande d'affichage. Dans le cas d'une pile hors tolérance, son remplacement est demandé et si cela n'est pas fait, le programme est bloqué dans cet état.

Dans la version avec mémorisation par tranches de durée décrite, deux boutons-poussoirs sont présentés, l'un 41 pour le défilement de l'affichage sur les afficheurs 38, l'autre 40 pour l'effacement de la mémoire. D'autres fonctions, obtenues par combinaison des deux boutons-poussoirs pourraient être envisagées, par exemple, la modification de la table de définition des tranches de durée. Dans la réalisation effective de cette version, le microcontrôleur analyse l'état des boutons poussoirs 40, 41 et entreprend les traitements correspondants. Il effectue en outre un traitement des rebonds pour s'assurer de la validité d'un ordre.

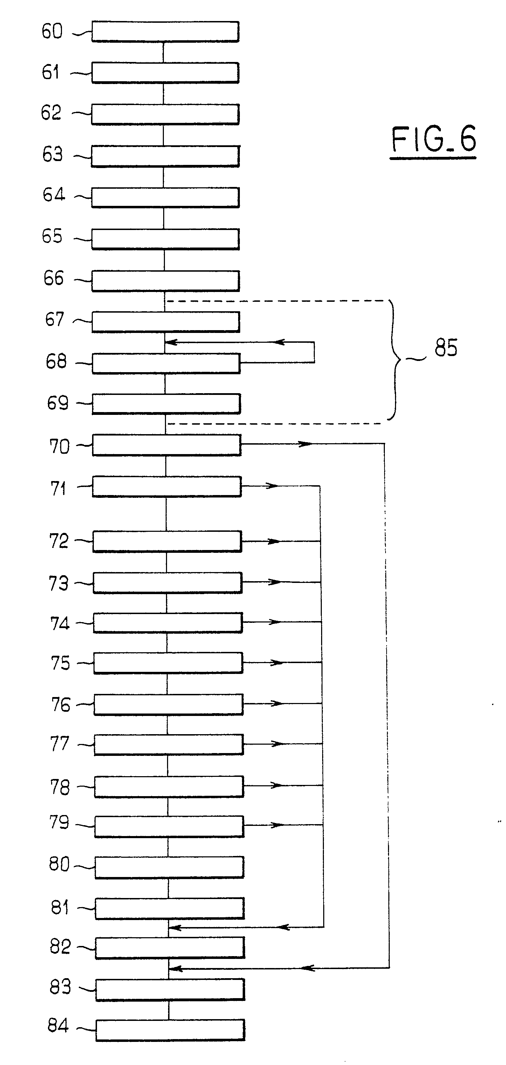

On va maintenant décrire les différentes étapes de la détection d'un défaut et de son traitement, en référence à la figure 6 et en combinaison avec les figures 3 et 4.

Supposons qu'un défaut, caractérisé par une chute de tension, apparaisse sur le réseau électrique auquel est relié le dispositif selon l'invention (étape 60), et active les moyens de détection 26. Les contacts 27a, 27b, normalement ouverts, sont alors fermés du fait de la désexcitation du relais 27 (étape 61).

La fermeture des contacts 27a, 27b provoque alors la mise en alimentation du micro-contrôleur 15 par la pile 31 via la porte logique OU 22 (étape 62).

La mise en alimentation du microcontrôleur conduit à une initialisation (RESET) de ce dernier (étape 63) qui entreprend alors l'exécution d'un microprogramme écrit dans sa mémoire interne 23.

Une première opération consiste pour lui à émettre un ordre d'automaintien à destination des moyens de commande 29 du relais d'automaintien 28, via la porte logique OU 30 (étape 64). L'initialisation du compteur de durée interne est ensuite effectuée (étape 65), sa valeur initiale de comptage étant fixée à zéro (étape 66) et son lancement est commandé (étape 67). Le compteur reste en activité (séquence 85) tant qu'un signal de détection de rétablissement n'est pas reçu par le microcontrôleur 15. Ce dernier sonde périodiquement sont port d'entrée (étape 68). Lorsque le rétablissement de la tension sur le réseau est détecté, le compteur est arrêté (étape 69) et la discrimination par tranches de durée est alors entreprise. Dans l'exemple décrit ici, dix tranches de durée sont prévues.

Un premier test 70 permet d'identifier une durée inférieure à la durée minimale. Si cette identification a lieu, l'étape 83 de suppression de l'automaintien de l'alimentation est directement effectuée, suivi de l'étape 84 d'arrêt du traitement.

Dans le cas contraire, la durée du défaut, matérialisée par le contenu du compteur, est successivement comparée à au plus 9 valeurs de limites de tranche croissantes, de préférence régulièrement réparties, lors des tests 71 à 79, jusqu'à ce que l'un des tests détermine la tranche dans laquelle le défaut doit être indexé.

L'étape 80 correspond au cas de la tranche supérieure qui inclut des défauts de durée supérieure à une durée prédéterminée. Une étape 81 d'incrémentation du compteur de tranches est ensuite effectuée.

Lorsque la durée d'un défaut a enfin été classée, un compteur d'évènements interne au microcontrôleur assure la mise à jour de la tranche concernée par le défaut en incrémentant une variable de cumul du nombre de défauts tout instant, en mémoire non volatile, du nombre de défauts associée à cette tranche (étape 82). On dispose de défauts détectés pour chaque tranche de durée.

Lorsque cette actualisation a eu lieu, le microcontrôleur 15 commande la suppression de sa propre alimentation en envoyant un ordre de désactivation du relais d'automaintien 28 par les moyens de commande 28, via la porte logique OU 30 (étape 83). La coupure de l'alimentation du microcontrôleur provoque bien entendu l'arrêt du traitement (étape 84).

En ce qui concerne le fonctionnement de la seconde version préférée du dispositif autonome de détection avec historique des défauts, les étapes 60 à 69, décrites pour le fonctionnement du dispositif avec tranches de durée, restent valables. Par contre, les étapes 70 à 82 de discrimination par tranches sont remplacés par une étape d'enregistrement de l'historique du défaut en cours (date, heure, durée, site) effectuée grâce aux moyens d'horloge 32 et à la mémoire de stockage non volatile 16, en référence à la figure 3.

Les données stockées dans la mémoire 16 sont transférées à l'extérieur du dispositif pour un traitement ultérieur de la façon suivante : un opérateur muni d'un terminal de saisie portable 14 accède à la face avant du dispositif en enlevant la plaque 51 du boîtier 43, en référence à la figure 5.

Ensuite, il relie le terminal de saisie portable 14 au dispositif, via le connecteur 50. Cette connexion assure, d'une part, la liaison série 18 du terminal de saisie portable 14 avec le microcontrôleur 15, et d'autre part, la mise en court-circuit par le strap 19 des bornes 20a et 20b (figure 3).

Cette mise en court-circuit a pour effet de mettre sous tension le microcontrôleur 15 via la porte logique OU 22. Le microcontrôleur 15 restera alimenté tant que le terminal de saisie portable 14 sera connecté à la partie de détection et d'analyse 33 du dispositif selon l'invention.

Le transfert des données de la mémoire 16 vers la mémoire interne du terminal 14 suivant des techniques de transmission série bien connues.

En ce qui concerne l'acquisition de la durée d'un défaut, le dispositif autonome de détection avc enregistrement historique comporte un système de limitation de la durée d'alimentation du microcontrôleur 15. Ainsi, dès qu'une certaine durée est dépassée, l'alimentation du microcontrôleur 15 est coupée. A intervalles fixes, assez courts pour ne pas trop diminuer la précision de la détection, l'horloge 52 envoie un signal d'alarme qui met le microcontrôleur sous tension. Le microcontrôleur 15 vérifie alors s'il y a rétablissement. Si ce n'est pas le cas, il couple l'alimentation et attend un autre cycle d'alarme.

Le microcontrôleur 15 est aussi chargé du contrôle des échanges avec le terminal de saisie portable 14 et permet de s'adapter au protocole spécifique de ce terminal (détection des signaux de poignée de main, reconnaissance de mots-clés, vitesse de transfert). A titre d'exemple, le microcontrôleur 15 reconnaît le protocole série V24.

La mémoire 16 est fonctionnellement divisée en deux espaces :
- la mémoire de donnée,
- la mémoire des paramètres de site.

Dans la mémoire de donnée, chaque enregistrement est constitué de la date et de l'heure du début de l'incident suivies de sa durée. L'enregistrement est séquentiel et l'enregistrement d'une case mémoire n'est effectué qu'une seule fois entre deux relevés.

Dans l'espace de la mémoire des paramètres de site, des paramètres spécifiques au site sont enregistrés, tels que, par exemple, le numéro de l'appareil, la localisation géographique, la localisation fonctionnelle. Ces paramètres sont lus par le terminal de saisie portable 14 afin que le système de traitement, auquel sont finalement destinées les données transférées, puisse identifier la provenance de ces données. Cet espace mémoire peut également contenir la valeur de la consigne de basculement et peut être remis à jour, par exemple, à partir du terminal de saisie portable 14.Pour des raisons de sécurité, son accès sera de préférence conditionné par l'emploi d'un mot de passe.

On va maintenant décrire un système intégré d'analyse de qualité de servide mettant en oeuvre des dispositifs autonomes de détection de défauts selon l'invention, et plus particulièrement des dispositifs avec enregistrement historique conformes à l'invention et présentant les caractéristiques suivantes :
- grandeur physique observée et consigne de baculement : la tension secteur,
- 10 seuils réglables, de 30% à 80% de la tension nominale,
- précision des seuils : 1 à 2
- durée minimale : 0,3 seconde,
- capacité de la mémoire : enregistrement de 1920 défauts,
- durée de la pile supérieure à 1 an,
- temps de transfert de la mémoire inférieur à 30 secondes,
- temps de changement de la pile inférieur à 1 minute,
- dérive de l'horloge : 10 secondes sur 6 mois.

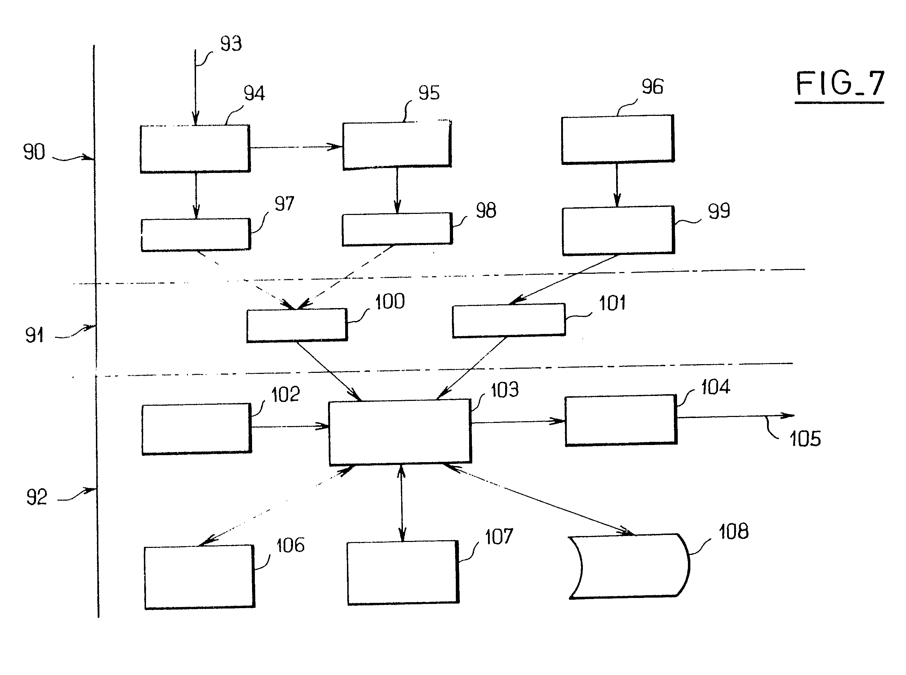

Le système intégré d'analyse de qualité de service suit la structure arborescente du réseau de distribution électrique représentée sur le schéma synoptique de la figure 7.

Il comporte trois phases : une phase de collecte 90, une phase de transfert 91 et une phase d'exploitation 92.

Des dispositifs autonomes de détection conformes à l'invention, 97, 98, appelés aussi témoins électroniques de continuité de tension (TECT), sont placés à chaque noeud de réseau, au niveau des postes de transformation haute tension/moyenne tension (HT/BT) 94, et moyenne tension/basse tension (MT/BT) 98 et éventuellement sur certains points terminaux du réseau, tels que des compteurs d'abonnés.

Les dispositifs autonomes de détection 97, 98 mémorisent la durée et la date de chaque incident et sont codifiés chacun selon son emplacement.

L'exploitant du réseau de distribution collecte les informations mémorisées dans les dispositifs autonomes de détection 97, 98, au moyen de terminaux de saisie portables 100 qui peut en outre être utilisés pour d'autres applications.

L'ensemble des informations collectées par les terminaux de saisie portables 100 est traité par un poste de traitement informatique 103 auquel sont associés un module d'acquisition de données 106, une table de correspondance 102, un module de traitement de données 107, de préférence un micro-ordinateur personnel, un module d'édition 108 et un modem 104 permettant des échanges d'informations entre le poste de traitement informatique 103 et des ordinateurs centraux via une ligne téléphonique 105.

A cette structure matérielle, sont bien entendu associés des moyens logiciels. Ainsi, chaque terminal de saisie portable 100 est équipé d'un logiciel de communication permettant le dialogue d'une part avec les dispositifs autonomes de détection 97, 98 et, d'autre part, avec le poste de traitement informatique 103.

Des moyens humains viennent contribuer au bon fonctionnement du système intégré d'analyse de qualité de service. Ainsi, l'exploitant 96 relève les informations de chaque dispositif autonome de détection et signale les incidents constatés de visu par le biais d'un formulaire d'incidents 99. Il effectue ensuite le transfert des informations consignées sur ces formulaires vers le poste de traitement informatique 103 au moyen du clavier 101.

Par ailleurs, les services techniques électriques donnent des compte-rendus de contrôles effectués sur le terrain et ces compte-rendus sont aussi fournis au poste de traitement informatique 103.

Bien entendu, l'invention n'est pas limitée aux exemples de réalisation que l'on vient de décrire et on peut apporter à ceux-ci de nombreuses modifications sans sortir du cadre de l'invention.

Ainsi, d'autres types de défauts peuvent être détectés, tels que des surtensions ou des surintensités. Il suffit pour cela de modifier les moyens de détection pour les adapter à la nouvelle consigne de basculement sans changer la structure générale du dispositif autonome de détection conforme à l'invention.

## Revendications

1. Dispositif autonome de détection de défauts sur un réseau électrique, comprenant :
- des moyens (26) pour détecter la présence de défauts sur le réseau électrique et délivrer des informations de détection, reliés audit réseau électrique par des bornes de raccordement (25),
- des moyens de contrôle et de traitement (15) reliés audits moyens de détection (26), pour traiter lesdites informations de détection et générer des données d'analyse de défaut,
- des moyens de stockage permanent (16) reliés auxdits moyens de contrôle et de traitement (15) pour stocker lesdites données d'analyse, et des moyens autonomes de stockage et de fourniture d'énergie (31) pour tout ou partie des moyens précités, caractérisé en ce que lesdits moyens de détection (26) détectent en outre les instants d'apparition et de disparition des défauts et en ce que lesdits moyens de contrôle et de traitement (15) déterminent la durée respective de chacun desdits défauts.

2. Dispositifs conforme à la revendication 1, caractérisé en ce qu'il comprend en outre des moyens pour contrôler (27, 28, 22) la fourniture d'énergie par lesdits moyens autonomes de stockage et de fourniture (31) auxdits moyens de contrôle et de traitement (15) en fonction de la détection éventuelle de défauts par lesdits moyens de détection et de demandes d'activation desdits moyens de contrôle et de traitement (15) extérieures audit dispositif.

3. Dispositif conforme à la revendication 2, caractérisé en ce que lesdits moyens pour contrôler la fourniture d'énergie (27, 28, 22) commandent l'alimentation en énergie desdits moyens de contrôle et de traitement (15) par lesdits moyens autonomes de stockage et de fourniture d'énergie (31) au moins pendant toute la durée de chaque défaut éventuel détecté par lesdits moyens de détection (26) et jusqu'à ce que les opérations de traitement et de génération des données d'analyse par lesdits moyens de contrôle et de traitement (15) et les opérations de stockage dans lesdits moyens de stockage permanent (16) aient été achevées.

4. Dispositif conforme à l'une des revendications 1 à 3, caractérisé en ce que lesdits moyens de contrôle et de traitement (15) comportent des moyens de comptage pour déterminer sensiblement la durée d'un défaut éventuel à partir des informations délivrées par lesdits moyens de détection (26), et des moyens pour associer à chaque tranche de durée appartenant à un ensemble de tranches de durée prédéterminées, un nombre égal au nombre de défauts détectés dont la durée est sensiblement comprise dans ladite tranche de durée, lesdits nombres de défauts par tranche de durée étant réactualisés par lesdits moyens de contrôle et de traitement (15) à chaque détection et stockés dans lesdits moyens de stockage permanent (16).

5. Dispositif conforme à l'une des revendications 1 à 4, caractérisé en ce qu'il comporte en outre des moyens d'horloge (32) reliés auxdits moyens de contrôle et de traitement (15), pour fournir auxdits moyens de contrôle et de traitement (15), lors de chaque détection et traitement d'un défaut, des informations de date et d'heure de début dudit défaut, et en ce que lesdits moyens d'horloge (32) sont alimentés en énergie de façon permanente par lesdits moyens autonomes de stockage et de fourniture d'énergie (31).

6. Dispositif conforme à l'une des revendications 3 à 5, caractérisé en ce qu'il comporte des moyens de saisie portables (14) pouvant être temporairement reliés audit dispositif pour permettre le transfert des données contenues dans lesdits moyens de stockage permanent (16) à l'extérieur dudit dispositif pour un traitement ultérieur desdites données, ledit transfert étant contrôlé par lesdits moyens de contrôle et de traitement (15).

7. Dispositif conforme à la revendication 6, caractérisé en ce que lesdits moyens pour contrôler la fourniture d'énergie (27, 28, 22) sont adaptés pour commander l'alimentation en énergie desdits moyens de contrôle et de traitement (15) par lesdits moyens autonomes de stockage et de fourniture d'énergie (31) pendant la durée du transfert par lesdits moyens de saisie portables (14) .

8. Dispositif conforme à l'une des revendications 3 à 7, caractérisé en ce qu'il comporte en outre des moyens d'affichage (38), reliés auxdits moyens de contrôle et de traitement (15), pour permettre la visualisation par un opérateur des données d'analyse stockées dans lesdits moyens de stockage permanent (16), des moyens de contrôle d'affichage (41) étant prévus pour, d'une part, transmettre auxdits moyens de contrôle et de traitement (15) une demande d'affichage et, d'autre part, contrôler le défilement des données affichées sur les moyens d'affichage (38).

9. Dispositif conforme à la revendication 8, caractérisé en ce que lesdits moyens pour contrôler la fourniture d'énergie (27, 28, 22) commandent l'alimentation en énergie desdits moyens de contrôle et de traitement (15) par lesdits moyens autonomes de stockage et de fourniture d'énergie (31) pendant une durée prédéterminée à l'issue d'une demande d'affichage par lesdits moyens de contrôle d'affichage (41).

10. Dispositif conforme à l'une des revendications 1 à 9, caractérisé en ce que lesdits moyens de détection (26) sont adaptés pour détecter toute coupure ou baisse en dessous d'un seuil prédéterminé de la tension sur le réseau électrique, et en ce que des moyens de réglage (37, 48) sont prévus pour fixer ledit seuil prédéterminé.

11. Dispositif conforme à la revendication 10, caractérisé en ce qu'il est inclus dans un boîtier (34, 43) dont la face avant comporte lesdits moyens de réglage (37, 48), lesdites bornes de raccordement (42, 49), et un logement contenant lesdits moyens autonomes de stockage et de fourniture d'énergie (39, 47).

12. Dispositif conforme a la revendication 11, caractérisé en ce que ladite face avant comporte en outre lesdits moyens d'affichage (38), lesdits moyens de contrôle d'affichage (41), et des moyens (40) pour commander l'effacement des données d'analyse stockées dans lesdits moyens de stockage permanent (16).

13. Dispositif conforme à la revendication 11, caractérisé en ce que ladite face avant comporte en outre des moyens de connexion (50) pour relier ledit dispositif auxdits moyens de saisie portables (14).

14. Dispositif conforme à l'une des revendications 11 à 13, caractérisé en ce que ladite face avant peut être masquée par des moyens de couverture (35, 51) plombables.

15. Dispositif conforme à l'une des revendications 1 à 14, caractérisé en ce que lesdits moyens de détection (26) prélèvent l'énergie nécessaire à leur fonctionnement à partir du réseau électrique analysé.

16. Dispositif conforme à la revendication 11, caractérisé en ce que ladite face avant comporte en outre des moyens de connexion d'affichage déporté permettant de relier des moyens d'affichage extérieurs audit dispositif, auxdits moyens de contrôle et de traitement (15) et en ce que lesdits moyens de connexion d'affichage déporté sont agencés de sorte que, lorsque ceux-ci sont utilisés, lesdits moyens de contrôle de fourniture d'énergie permettent l'alimentation desdits moyens de contrôle et de traitement (15) par lesdits moyens autonomes de stockage et de fourniture d'énergie (31).

17. Procédé de détection et d'analyse de défauts sur un réseau électrique, mis en oeuvre dans le dispositif selon l'invention, comprenant :
- une étape de détection (60) de la présence d'un défaut sur le réseau électrique, par des moyens de détection de défaut (26), suivie
- d'une étape d'analyse dudit défaut, par des moyens de contrôle et de traitement (15), et
- une étape de stockage des résultats d'analyse obtenus lors de l'étape précédente dans des moyens de stockage permanent (16),
caractérisé en ce que ladite étape d'analyse est initiée par l'apparition du défaut lui-même, et en ce que lors de cette étape, la durée du défaut est déterminée par lesdits moyens de contrôle et de traitement (15).

18. Procédé conforme à la revendication 17, caractérisé en ce que ladite étape comprend :
- une étape de mise en service (62) desdits moyens de contrôle et de traitement (15), dès l'apparition d'un défaut,
- une étape d'initialisation et de lancement (65, 66) de moyens de comptage appartenant auxdits moyens de contrôle et de traitement (15),
- une étape de comptage temporel (85) interrompue dès la détection de la disparition du défaut par lesdits moyens de détection (26), fournissant alors la durée dudit défaut.

19. Procédé conforme à la revendication 18, caractérisé en ce que ladite étape d'analyse comporte en outre une succession d'étapes de discrimination (70 - 79) au cours desquelles la durée du défaut, déterminée lors de l'étape de détection précédente (60), est successivement comparée à une série de seuils prédéterminés de durée définissant des tranches prédéterminées de durée, jusqu'à ce que ladite durée du défaut puisse être classée dans l'une desdites tranches prédéterminées.

20. Procédé conforme à la revendication 19, caractérisé en ce que ladite étape d'analyse comporte en outre, à la suite desdites étapes de discrimination, une étape d'actualisation des nombres cumulés de défauts détectés pour chacune desdites tranches de durée prédéterminées et en ce que ladite étape de stockage comprend le transfert desdits nombres cumulés de défauts par tranche de durée, après actualisation, dans lesdits moyens de stockage permanent (16).

21. Procédé conforme à l'une des revendications 18 à 20, caractérisé en ce que ladite étape d'analyse comporte en outre une étape d'enregistrement, au cours de laquelle la durée du défaut, déterminée lors de l'étape de détection précédente, est associée à la date et à l'heure de début dudit défaut délivrées par des moyens d'horloge (52), reliés auxdits moyens de contrôle et de traitement (15) et en ce que ladite étape de stockage comprend le transfert d'un enregistrement, constitué par la juxtaposition desdites date et heure de début du défaut et de la durée de ce dernier, desdits moyens de contrôle et de traitement (15) dans lesdits moyens de stockage permanent (16).

22. Procédé conforme à l'une des revendications 18 à 21, caractérisé en ce qu'il comprend en outre, à l'issue de ladite étape de stockage, une étape de mise hors service (83) desdits moyens de contrôle et de traitement (15), jusqu'à une prochaine détection de défaut.

23. Procédé conforme à l'une des revendications 18 à 22, caractérisé en ce qu'il comprend en outre une étape de mise en service desdits moyens de contrôle et de traitement (15) pouvant être initiée par des commandes extérieures audit dispositif, notamment pour un transfert ou une visualisation des données stockées dans lesdits moyens de stockage permanent (16).

FIG_1

FIG_2

FIG_3

FIG_4

FIG_5

## FIG.6

FIG_7